# EUROPÄISCHE PATENTSCHRIFT

(11) **EP 1 352 457 B1**
(45) Veröffentlichungstag und Bekanntmachung des Hinweises auf die Patenterteilung: **25.06.2008**
(21) Anmeldenummer: 02704574.9
(22) Anmeldetag: 09.01.2002
(51) Int. Cl.: H02B 1/46, H05K 5/02

(54) **GEHÄUSE, INSBESONDERE FÜR DEN EINBAU ELEKTRISCHER UND ELEKTRONISCHER BAUTEILE**
HOUSING, IN PARTICULAR FOR THE INSTALLATION OF ELECTRICAL AND ELECTRONIC COMPONENTS
BOITIER, EN PARTICULIER POUR LE MONTAGE DE COMPOSANTS ELECTRIQUES ET ELECTRONIQUES

(30) Priorität: 16.01.2001 DE 10101618
(43) Veröffentlichungstag der Anmeldung: 15.10.2003
(73) Patentinhaber: Rolec Gehäuse-Systeme GmbH, 31737 Rinteln (DE)
(72) Erfinder: ROSE, Friedhelm, 32457 Porta Westfalica (DE); ROSE, Matthias, 31737 Rinteln (DE)
(74) Vertreter: Seewald, Jürgen
(86) Internationale Anmeldenummer: PCT/DE2002/000065
(87) Internationale Veröffentlichungsnummer: WO 2002/056437

(56) Entgegenhaltungen:
- DE-U- 9 216 735
- GB-A- 1 306 649
- US-A- 5 133 108

## Beschreibung

Die vorliegende Erfindung betrifft ein Gehäuse, insbesondere für den Einbau elektrischer und elektronischer Bauteile, bestehend aus einem Gehäuse-Unterteil und einem daran befestigbaren Deckel gemäß dem Oberbegriff des Anspruchs 1.

Handelsübliche Gehäuse, vorwiegend aus Aluminium aber auch aus glasfaserverstärktem Polyester oder aus thermoplastischem Kunststoff, haben im Gehäuse-Unterteil in den Eckbereichen jeweils eine Gewindebohrung für die Befestigung eines Deckels, der dazu mit Durchgangsbohrungen mit einer Senkung für den Schraubenkopf versehen ist. Aus Material- und Gewichtsersparnisgründen schließt sich an die Gewindebohrungen axial mit diesen fluchtend ein bis auf die Unterteil-Unterseite durchgehender Kanal an, dessen lichte Weite größer als der Durchmesser der Gewindebohrung ist. Parallel zu diesen Kanälen und in der Regel unmittelbar daneben verläuft jeweils ein Befestigungskanal von der Unterteil-Oberseite bis zur Unterteil-Unterseite durch. Dieser Kanal dient der Befestigung des Unterteils an einer Unterlage. Er ist an seinem unteren Ende auf eine geringere lichte Weite abgestuft, so daß sich ein Auflagebund für einen Schraubenkopf ergibt.

Es besteht bei den Anwendern derartiger Gehäuse oft der Wunsch, Gehäuse-Unterteil und Deckel in einer Weise miteinander zu verbinden, daß eine Art Deckelgelenk entsteht. Im Gehäuse-Unterteil und im Deckel werden häufig elektrotechnische und/oder elektronische Komponenten montiert, die durch Kabel oder Leiterbahnen miteinander verbunden sind. Es ist wichtig, daß diese Verbindungen bei geöffnetem Deckel nicht durch Zug belastet werden. Aus verschiedenen Gründen bevorzugen Gehäuseanwender dabei innenliegende Deckelgelenke, also Gelenke, die bei geschlossenem Deckel nach außen nicht sichtbar sind.

Ein in DE 92 16 735 U1 offenbartes Drahtseil-Scharnier erfüllt diese Forderungen. Dieses Scharnier besteht aus einem Drahtseilstück, dessen eines Ende in eine Deckelschraube eingewalzt ist. Diese Deckelschraube weist dazu an ihrem kopffernen Ende eine axiale Sackbohrung auf, in die das Seilstück vor dem Einwalzen eingesteckt wird. Auf das andere Drahtseilende ist in gleicher Weise ein Gewindestift aufgewalzt, dessen Gewindedurchmesser dem der Deckelschraube entspricht. Damit sind die Deckelschraube und der Gewindestift drehfest mit dem Drahtseilstück verbunden. Zur Montage des Scharniers wird das Ende mit dem Gewindestift durch die Deckelbohrung hindurchgesteckt und dann durch die für die Deckelschraube bestimmte Gewindebohrung im Gehäuse-Unterteil hindurchgeschraubt. Da sich die Gewindebohrung, wie weiter oben schon ausgeführt wurde, nach unten hin zu einem Kanal erweitert, fällt das Drahtseil-Scharnier insgesamt so weit nach unten in den Kanal, bis die Deckelschraube mit ihrem unteren Ende auf dem Gehäuse-Unterteil aufliegt: Ein Zurückziehen des Drahtseil-Scharniers ist nun nur noch so weit möglich, bis das obere Ende des Gewindestiftes am unteren Ende der Gewindebohrung anliegt. Die Deckelschraube kann nun in die Gewindebohrung des Gehäuse-Unterteils eingeschraubt werden. Dieser Montagevorgang wird an der anderen Ecke der gleichen Gehäuseseite wiederholt. Nun können auch die anderen Deckelschrauben eingeschraubt werden.

Zum Öffnen des Deckels werden alle Deckelschrauben, auch die in das Drahtseil-Scharnier integrierten, aus den Gewindebohrungen des Gehäuse-Unterteils herausgeschraubt. Der Deckel kann nun um seine Scharnierseite herumgeklappt werden. Dabei werden die Drahtseile aus den Kanälen so weit herausgezogen, bis die Oberseiten der Gewindestifte von unten an die Gewindebohrungen anstoßen. Die Gewindestifte wirken somit im Zusammenspiel mit der Unterseite der Gewindebohrungen als Stopper. Die Länge der Drahtseilstücke ist dabei so bemessen, daß der gewünschte Schwenkwinkel des Deckels erreicht wird. Auf seiner Außenseite wird der Deckel durch die Deckelschrauben des Drahtseil-Scharniers gehalten, die in den Deckelbohrungen sitzen.

In der Praxis hat sich gezeigt, daß diese bekannten Drahtseil-Scharniere störanfällig sind, da die Einwalzungen der Drahtseilenden nicht immer sicher halten. Zudem ist dieses Scharnier relativ aufwendig in seiner Herstellung.

Ein weiterer Nachteil ist darin zu sehen, daß das oben beschriebene Drahtseilscharnier bei den Gehäuse-Herstellern mit unterschiedlichen Schraubenköpfen - Schlitz-, Imbus-Kopf etc. - je nach den Wünschen des Kunden - bereitgehalten werden müssen. Der Lagerhaltungs-Aufwand wird darüber hinaus dadurch noch weiter erhöht, daß für unterschiedliche Deckelhöhen auch unterschiedlich lange Deckelschrauben erforderlich sind.

Gleiche oder ähnliche Nachteile hat ein in DE-OS 20 29 983 beschriebenes Gehäuse. Hier besteht das Verbindungsteil von Deckel und Gehäuse-Unterteil aus einem gerändelten Betätigungsknopf, an dem ein Ende einer biegsamen Welle, vorzugsweise aus Thermoplast, befestigt ist. Diese Welle läuft im montierten Zustand durch eine langgestreckte Hülse, die auf der Welle verdreh- und axial verschiebbar ist. Am anderen Ende der Welle ist eine Kappe durch Verschraubung befestigt.

Zum Befestigen des Deckels am Gehäuse-Unterteil wird zunächst die Welle des Verbindungsteils mit dem daran befestigten Betätigungsknopf von oben durch eine Durchgangsbohrung in einer Ecke des Deckels hindurchgesteckt. Anschließend wird von unten die Hülse auf die Welle aufgeschoben und die Kappe an dem dem Betätigungsknopf abgewandten Ende der Welle angeschraubt. Die Hülse kann jetzt nicht mehr von der Welle rutschen, da der Durchmesser der Kappe größer ist als der kleinste Innendurchmesser der Hülse, der in deren oberen Bereich vorliegt. Der mit einem Außengewinde versehene untere Bereich der Hülse wird nun in eine Gewindebohrung des Gehäuse-Unterteils eingeschraubt. Ein mittlerer Bereich der Hülse ist dazu sechskantig für den Ansatz eines Maulschlüssels ausgeführt. Nun wird der Deckel aufgesetzt. Die Hülse ist so lang, daß ihr mit einem Außengewinde ausgestattetes oberes Ende in die Durchgangsbohrung des Deckels hineinragt. Der Betätigungsknopf besitzt einen nach unten abragenden, hohlzylindrischen Ansatz, mit einem Innengewinde. Mittels dieses Gewindes wird der Betätigungsknopf auf das obere Ende der Hülse aufgeschraubt, wodurch der Deckel fest mit dem Gehäuse-Unterteil verbunden ist. Die beschriebene Verbindung ist an der anderen Ecke der gleichen Gehäuseseite identisch realisiert.

Zum Lösen der Verbindung werden die Betätigungsknöpfe von den Hülsen abgeschraubt. Da die Wellen eine ausreichende Länge haben, kann der Deckel so weit vom Gehäuse-Unterteil abgehoben und verschwenkt werden, bis die Kappen an die kleineren Innendurchmesser der Hülsen anschlagen. Der Deckel hängt nun geöffnet und unverlierbar am Gehäuse-Unterteil.

In der DE 196 00 260 C1 ist ein weiteres Innenscharnier zur Unterbringung im Verschraubungskanal eines Gehäuses beschrieben. Dieses Innenscharnier besitzt ein jeweils röhrenförmig ausgebildetes oberes Teil und unteres Teil, wobei diese beiden Teile gelenkig miteinander verbunden sind. Das untere Teil besitzt ein Innen- und Außengewinde. Das Außengewinde wird in das Gehäuse-Unterteil eingeschraubt. Zur Befestigung des Deckels am Gehäuse-Unterteil ist eine Schraube durch das röhrenförmige Innenscharnier hindurchgeführt und mit seinem unteren Ende in das Innengewinde des unteren Teils des Innenscharniers eingeschraubt. Das obere Innenscharnierteil besitzt ebenfalls ein Innengewinde mit dem gleichen Durchmesser wie das Innengewinde des unteren Innenscharnierteils. Zum Lösen des Deckels wird die Schraube aus dem Innengewinde des unteren Innenscharnierteils herausgeschraubt. Beim Abheben des Deckels vom Gehäuse-Unterteil verschiebt sich die Schraube im oberen Innenscharnierteils so weit, bis sein Gewindeteil an das Innengewinde des oberen Innenscharnierteils anschlägt. Der Deckel hängt dann aufgrund der flexiblen Verbindung von oberem und unterem Innenscharnierteil am Gehäuse-Unterteil.

Die DE 199 24 168 A1 beschreibt eine Befestigungsvorrichtung zur Verbindung von zwei Gehäusehälften eines Installationsgerätes. Bei dieser Befestigungsvorrichtung weist eine erste Gehäusehälfte mindestens eine Bolzenstange auf, deren Ende mit mindestens einem Schnapphaken versehen ist. Die zweite Gehäusehälfte hat ein Verbindungspodest mit einer Ausnehmung, die zum Durchstecken des Schnapphakens geeignet ist. Die Ausnehmung ist mit einem Hinterschnitt zur Arretierung des Schnapphakens ausgestattet.

Aufgabe der vorliegenden Erfindung ist es, ein gattungsgemäßes Gehäuse zur Verfügung zu stellen, welches die oben genannten Nachteile nicht aufweist.

Diese Aufgabe wird erfindungsgemäß durch ein Gehäuse mit den Merkmalen des Anspruchs 1 gelöst.

Das erfindungsgemäße Gehäuse gestattet eine sehr einfache und schnelle Montage seiner flexiblen, bei geöffnetem Deckel als Zugentlastung für Kabelverbindungen zwischen im Gehäuse-Unterteil und im Deckel montierten Bauteilen wirkenden Innenelemente. Wenn beide Enden dieser Elemente mit einer einfederbaren Verdickung ausgestattet sind, müssen diese lediglich von unten bzw. oben durch die Durchgangsöffnungen im Deckel bzw. Gehäuse-Unterteil hindurchgesteckt werden, bis die einfederbaren Verdikkungen nach dem Passieren der Durchgangsöffnungen zurückschnappen und hinter deren Randungen verrasten. Der Deckel ist nach diesem Montagevorgang scharnierartig am Gehäuse-Unterteil festgelegt. Es versteht sich dabei von selbst, daß die Verrastungen kräftemäßig so ausgelegt sind, daß sie unter der Last des an den flexiblen Innenelementen hängenden Deckels und ggf. darin montierter Bauteile nicht nachgeben, also einen sicheren Halt des geöffneten. Deckels am Gehäuse-Unterteil gewährleisten. Der Öffnungswinkel des Deckels ist dabei, wie beim Stand der Technik auch, durch die Länge der flexiblen Elemente bestimmt. Wenn nur ein Ende der flexiblen Elemente einfedernd und das andere gewissermaßen starr ausgeführt ist, gestaltet sich die Montage so, daß das flexible Element mit seinem einfedernden Ende nacheinander durch die Durchgangsöffnungen von Deckel und Gehäuse-Unterteil bzw. umgekehrt, hindurchgesteckt wird, bis dieses zurückschnappt und hinter dem Rand der Deckel- bzw. Gehäuse-Unterteilöffnung verrastet.

In vorteilhafter Ausgestaltung der Erfindung sind die flexiblen Innenelemente als Kunststoff-Spritzgußteil mit einem angeformten, einfederbaren Rastelement an ihrem einen Ende und einer angeformten Verdickung an ihrem anderen Ende ausgeführt. Ein derartiges Spritzgußteil ist sehr kostengünstig herstellbar, so daß es jedem Gehäuse als Option für einen Gehäuseanwender beigelegt werden kann, ohne dafür einen Aufpreis berechnen zu müssen. Bei den bisher bekannten Lösungen müssen Gehäuseanwender für die flexiblen Scharnierelemente einen Aufpreis zahlen, da deren. Herstellung relativ teuer ist.

Es ist weiterhin von Vorteil, wenn die Durchgangsöffnungen im Deckel zur formschlüssigen und bündigen Aufnahme der angeformten Verdickung ausgebildet sind. Damit ragt dieses Ende der flexiblen Elemente nicht aus der Oberfläche des die Durchgangsöffnung umgebenden Bereichs des Deckels hervor. Gleichzeitig schließt es den Querschnitt der Durchgangsöffnung, so daß sich ein optisch ansprechendes Erscheinungsbild ergibt.

Vorteilhafte Weiterbildungen der Erfindung ergeben sich aus den übrigen Unteransprüchen.

Die Erfindung wird nachstehend anhand eines Ausführungsbeispiels näher erläutert. In der dazugehörigen Zeichnung zeigt:

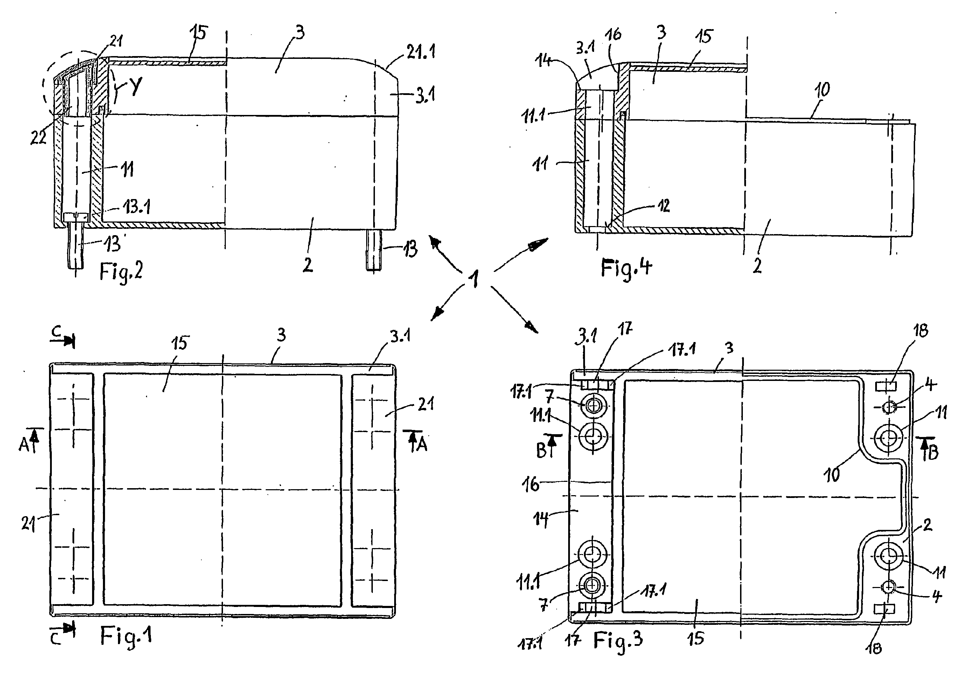

- Fig. 1: eine Draufsicht auf ein Gehäuse bei geschlossenem Deckel mit aufgesteckten Abdeckprofilen,
- Fig. 2: einen Schnitt A-A gemäß Fig. 1, wobei nur die linke Gehäusehälfte geschnitten dargestellt ist,
- Fig. 3: eine Draufsicht auf das Gehäuse, wobei die rechte Gehäusehälfte bei abgenommenem Deckel und die linke Gehäusehälfte bei geschlossenem Deckel, aber entferntem Abdeckprofil, dargestellt ist,
- Fig. 4: einen Schnitt B-B gemäß Fig. 3, wobei nur die linke Gehäusehälfte geschnitten dargestellt ist,
- Fig. 5: einen Schnitt C-C gemäß Fig. 1,
- Fig. 6: eine Darstellung gemäß Fig. 5 bei geöffnetem Deckel,
- Fig. 7: eine Darstellung eines flexiblen Innenelements in Vorderansicht,
- Fig. 8: einen Schnitt D-D gemäß Fig. 7,
- Fig. 9: eine Einzelheit X gemäß Fig. 5 in einem vergrößerten Maßstab, und
- Fig. 10: eine Einzelheit Y gemäß Fig. 2 ebenfalls in einem vergrößertem Maßstab.

Bei dem in der Zeichnung gezeigten Gehäuse 1 handelt es sich um ein Aluminiumgehäuse mit rechteckigem Grundriß. Dieses Gehäuse 1 besteht aus einem Gehäuse-Unterteil 2, welches nach unten geschlossen und nach oben offen ist, sowie einem Deckel 3 zum Schließen des Gehäuse-Unterteils 2. In jeder der vier Ecken des Gehäuse-Unterteils 2 ist eine Gewindebohrung 4 vorgesehen, die sich nach unten in einen Kanal 5 öffnet, der bis zur Unterseite des Gehäuse-Unterteils 2 durchgeht. Diese Gewindebohrungen 4 dienen der Verschraubung des Deckels 3 mit dem Gehäuse-Unterteil 2. Dazu sind im Deckel 3 abgestufte Durchgangsbohrungen 6 vorgesehen, die einen oberen Senkbereich 6.1 für die Aufnahme des Schraubenkopfes 7.1 einer Deckelschraube 7 und einen sich daran anschließenden Bohrungsbereich 6.2 aufweisen, der bei verschraubtem Deckel mit etwas radialem Spiel vom Schraubenschaft 7.2 durchsetzt wird. Wenn alle vier Deckelschrauben 7 angezogen sind, sitzt der Deckel 3 fest auf dem Gehäuse-Unterteil 2. Eine im Deckel umlaufende Nut 8 mit eingelegter Dichtung 9 und eine in die Nut 8 eingreifende, am Gehäuse-Unterteil 2 umlaufende Leiste 10 sorgen dabei für einen dichten Sitz des Deckels 3 auf dem Gehäuse-Unterteil 2.

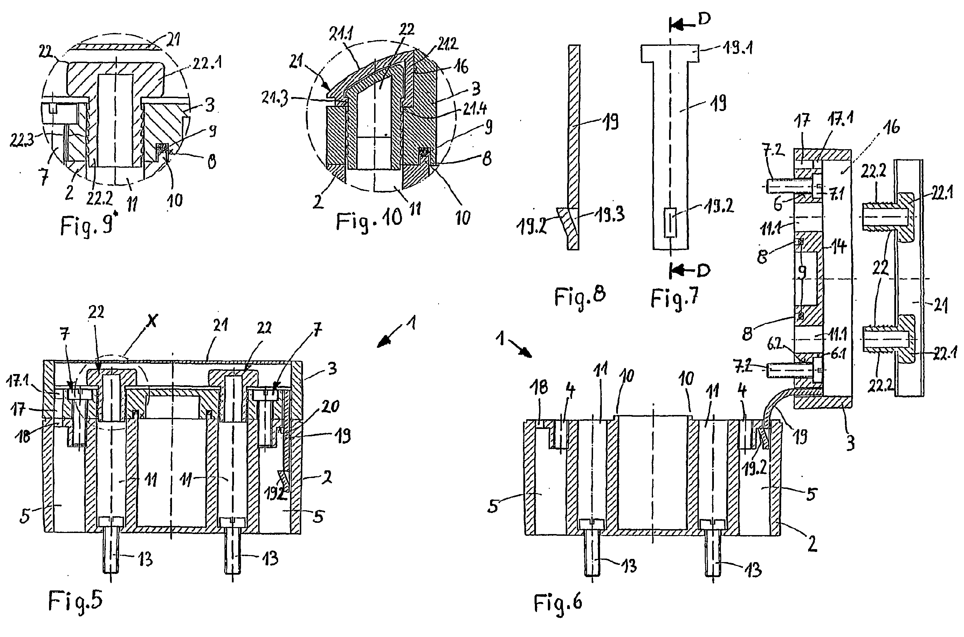

Im Bereich jeder Ecke des Gehäuse-Unterteils 2 verläuft neben dem Kanal 5 und parallel zu diesem ein Befestigungskanal 11, der in seinem oberen Bereich einen größeren Durchmesser besitzt als in seinem unteren Bereich, wodurch dort eine Schulter 12 gebildet ist, die ein Widerlager für den Kopf 13.1 einer Befestigungsschraube 13 bildet, mit der das Gehäuse-Unterteil 2 z. B. an eine Wand angeschraubt werden kann. Die Befestigungskanäle 11 setzen sich nach oben im Deckel 3 in Abschnitten 11.1 fort und münden dort in einer Ebene 14, die unterhalb der Deckelfläche 15 liegt und durch eine entsprechende Abstufung 16 des Deckelrandbereiches gebildet ist. Diese Ebene 14 erstreckt sich über die gesamte Deckelbreite und ist seitlich durch Fortsätze 3.1 der Seitenwandung des Deckels 3 begrenzt. Sie ist auf zwei sich gegenüberliegenden Deckelseiten identisch vorhanden. In die Ebenen 14 mündet auch der Senkbereich 6.1 der Durchgangsbohrungen 6 für die Deckelschrauben 7. Wenn der Deckel 3 auf das Gehäuse-Unterteil 2 aufgesetzt ist und die Deckelschrauben 7 angezogen sind, schließen die oberen Stirnflächen der Schraubenköpfe 7.1 bündig mit der Ebene 14 ab (Fig. 5).

In den Ecken des Deckels 3 sind neben den Gewindebohrungen 4 und den Fortsätzen 11.1 der Befestigungskanäle 11 weitere Durchgangsöffnungen 17 vorgesehen, welche mit entsprechenden Durchgangsöffnungen 18 im Gehäuse-Unterteil 2 fluchten. Während die Durchgangsöffnungen 17 an ihren oberen Enden in der Ebene 14 münden, münden die Durchgangsöffnungen 18 an ihren unteren Enden in die Kanäle 5. Beide Durchgangsöffnungen 17, 18 besitzen einen identischen rechteckigen Querschnitt, der sich an den oberen Enden der Durchgangsöffnungen 17 durch seitliche Fortsätze 17.1 hammerkopfartig erweitert. Sie sind ebenso wie die Durchgangsbohrungen 6, die Gewindebohrungen 4, die Kanäle 5, die Befestigungskanäle 11 und ihre Fortsätze 11.1 außerhalb des abgedichteten Innenraums des Gehäuses 1 angeordnet, dessen Begrenzung durch die im Deckel 3 und Gehäuse-Unterteil 2 umlaufende Nut 9 bzw. Feder 10 gegeben ist. Diese Ausbildung geht am besten aus Fig. 5 hervor.

Die Durchgangsöffnungen 17, 18 dienen der Aufnahme und Festlegung von Scharnierbändern 19. Ein solches Scharnierband 19 ist als Einzelteil in den Figuren 7 und 8 dargestellt. Es handelt sich dabei um ein Spritzgußteil aus einem flexiblen Kunststoff. Sein Querschnitt ist in dem zwischen den beiden Enden liegenden Bereich an den Querschnitt der Durchgangsöffnungen 17, 18 angepaßt, so daß dieser Bereich problemlos durch die Durchgangsöffnungen 17, 18 hindurchgesteckt werden kann. An seinen Enden weist das Scharnierband 19 Querschnittsverdickungen auf. Am (bezogen auf die Fig. 7 und 8) oberen Ende besteht diese Querschnittsverdickung aus einer unnachgiebigen seitlichen Erweiterung nach Art eines Hammerkopfes 19.1, dessen Form mit der hammerkopfartigen Erweiterung 17.1 der Durchgangsöffnung 17 identisch ist, so daß er in dieser formschlüssig aufgenommen werden kann. Am unteren Ende des Scharnierbandes 19 besteht die Querschnittsverdickung aus einer angespritzten, widerhakenartigen Federzunge 19.2, welche aufgrund einer Aussparung 19.3 im Material des Scharnierbandes 19 nach innen einfedern kann.

Die Scharnierbänder 19 dienen der scharnierartigen Verbindung von Deckel 3 und Gehäuse-Unterteil 2. Sie liegen dem Gehäuse 1 stets als Option bei, ohne daß dafür, da es sich dabei um sogenannte Pfennigartikel handelt, einen Aufpreis zu zahlen ist. Da es bei der Herstellung des Gehäuses 1 weiterhin unproblematisch ist, die Durchgangsöffnungen 17, 18 in der Gußform vorzusehen, sind diese ebenfalls ohne Aufpreis bei allen ausgelieferten Gehäusen vorhanden. Ein Gehäuseanwender muß daher erst nach dem Kauf entscheiden, ob er eine scharnierartige Verbindung von Deckel 3 und Gehäuse-Unterteil 2 realisieren will oder nicht. Bei den nach dem Stand der Technik bekannten Lösungen muß er diese Entscheidung vor dem Kauf bzw. der Bestellung des Gehäuses treffen und für die notwendigen zusätzlichen Bauteile bzw. Vorkehrungen am Gehäuse einen Aufpreis zahlen.

Die Montage eines Scharnierbandes 19 gestaltet sich sehr einfach. Dieses wird dazu zunächst mit seinem unteren Ende, also dem Ende, an dem die Federzunge 19.2 angeordnet ist, von der Deckeloberseite in die Durchgangsöffnung 17 hinein gedrückt. Bei entsprechendem Druck federt die Federzunge 19.2 ein, so daß das Scharnierband 19 so weit durch die Durchgangsöffnung 17 hindurchgedrückt werden kann, bis dessen Hammerkopf 19.2 formschlüssig in die entsprechende Querschnittserweiterung 17.1 am oberen Ende der Durchgangsöffnung 17 eingreift. Das vom Deckel 3 nach unten abragende Ende des Scharnierbandes 19 wird nun in gleicher Weise durch die Durchgangsöffnung 18 im Gehäuse-Unterteil 2 gedrückt. Nach dem Passieren der Durchgangsöffnung 18 federt die Federzunge 19.2 wieder nach außen. Das Scharnierband 19 kann nun weder nach unten aus der Durchgangsöffnung 17 noch nach oben aus der Durchgangsöffnung 18 herausgezogen werden, da dies durch die Querschnittsverdickungen (Hammerkopf 19.1, Federzunge 19.2) verhindert wird. Ein Lösen dieser Verbindung ist nur möglich, wenn die Federzunge 19.1 durch übermäßigen Zug abgerissen oder aber bewußt, z. B. mittels eines Schraubendrehers von unten durch den Kanal 5 hindurch querschnittsverringernd einwärts gedrückt wird.

Es werden jeweils immer zwei Scharnierbänder 19 auf einer Gehäuseseite montiert, deren gedachte Verbindungslinie gewissermaßen die Scharnierachse bildet. Ein Gehäuseanwender hat dabei die Wahl, die eine oder die andere Seite des Gehäuses für die Montage der Scharnierbänder 19 zu nutzen, da die Durchgangsöffnungen 17, 18 an jeder Gehäuseecke vorgesehen sind.

Bei auf das Gehäuse-Unterteil 2 aufgesetztem Deckel 3 hängen die Scharnierbänder 19 an letzterem und ragen mit ihren unteren Enden in die Kanäle 5, die lang genug sind, um die Scharnierbänder 19 aufzunehmen. Nach dem Lösen der Deckelschrauben 7 kann der Deckel 3 auf der Gehäuseseite, auf der die beiden Scharnierbänder 19 installiert sind, nach außen geschwenkt werden, wodurch die Scharnierbänder 19 so weit aus den Kanälen 15 herausgezogen werden, bis die Federzungen 19.2 an den unteren Rand 20 der Durchgangsöffnungen 18 anschlagen und so ein weiteres Herausziehen verhindern. Diese Situation ist in Fig. 6 dargestellt. Der Deckel 3 kann nun noch weiter verschwenkt werden, bis er, von den Scharnierbändern 19 gehalten, frei am Gehäuse-Unterteil 2 hängt. Die Auszugslänge der Scharnierbänder 19, die sich aus dem Abstand zwischen dem unteren Rand 20 der Durchgangsöffnungen 18 und dem freien Ende der Federzunge 19.2 ergibt, ist dabei so gewählt, daß eventuelle Kabelverbindungen zwischen im Deckel 3 bzw. Gehäuse-Unterteil 2 montierten Bauelementen zugentlastet sind.

Obwohl die Hammerköpfe 19.1 der Scharnierbänder 19 im eingebauten Zustand (Fig. 5) ebenso wie die Köpfe 7.1 der Deckelschrauben 7 bündig mit den Ebenen 14 abschließen, ist diese Lösung optisch nicht ansprechend, zumal auch die Fortsätze 11.1 der Befestigungskanäle 11 in den Ebenen 14 offen liegen. Da diese Ebenen 14 unterhalb des Niveaus der Deckelfläche 15 liegen, bietet sich die Möglichkeit an, diese Bereiche abzudecken. Dazu ist jeweils für jede Ebene 14 ein Abdeckprofil 21 aus Aluminium vorgesehen. Die Länge dieses Abdeckprofils 21 ist an den Abstand zwischen den Fortsätzen 3.1 der Seitenwände des Deckels 3 in dem Sinne angepaßt, daß es diesen Abstand mit geringem seitlichen Spiel ausfüllt. Dabei ist der Querschnitt des Abdeckprofils 21 so gestaltet, daß dieses den durch die Abstufung 16 im Deckelrandbereich entstandenen Sprung in der Deckelflächenkontur ausgleicht, indem sich seine Oberfläche 21.1 vom Niveau der Deckelfläche 15, von oben gesehen, konkav auf das Niveau der Ebene 14 absenkt. Entsprechend dieser Krümmung besitzt das Abdeckprofil 21 einen längeren Innenschenkel 21.2 und einen kürzeren Außenschenkel 21.3 (Fig. 10). Vom Innenschenkel 21.2 und Außenschenkel 21.3 ragen kurze Leisten 21.4 senkrecht nach innen ab, die der Halterung von zwei Haltezapfen 22 aus Kunststoff am Abdeckprofil 21 dienen. Diese Haltezapfen 22 besitzen einen Kopf 22.1 sowie einen davon nach unten abragenden zylindrischen Schaft 22.2. Der Kopf 22.1 ist mit sich diametral gegenüberliegenden Nuten 21.3 versehen, die ein Einschieben der Haltezapfen 21 von der Seite her in das Abdeckprofil 21 gestatten. Dadurch sind die Haltezapfen 22 nach ihrem Einschieben in das Abdeckprofil 21 gegen Herausziehen nach unten gesichert.

Der Abstand der Haltezapfen 22 zu den Enden de Abdeckprofils 21 ist so gewählt, daß ihre Schäfte 22.2 mit den Fortsätzen 11.1 der Befestigungskanäle 11 fluchten. Des weiteren ist der Durchmesser der Schäfte 22.2 auf den Durchmesser der Fortsätze 11.1 so abgestimmt, daß sich die Haltezapfen 22 relativ leicht in die Fortsätze 11.1 eindrücken lassen, aber dennoch sicher in diesen gehalten sind. Um dies zu gewährleisten, sind die Schäfte 22.2 mit umlaufenden widerhakenartigen Lippen 22.3 ausgestattet, die dem Herausziehen der Haltezapfen 22 aus den Fortsätzen 11.1 einen Widerstand entgegensetzen, ein derartiges Herausziehen bei Bedarf aber dennoch ermöglichen.

Nach dem Befestigen des Gehäuses 1 an einem Untergrund durch Festziehen der Schrauben 13 und dem Aufschrauben des Deckels 3 auf das Gehäuse-Unterteil 2 wird der Deckel 3 durch das Aufstecken der Abdeckprofile 21, wie oben beschrieben, komplettiert. Es ergibt sich dadurch eine einheitliche Deckeloberfläche, die sich aus der Deckelfläche 15 und den Oberflächen 21.1 der Abdeckprofile 21 zusammensetzt. Wenn das Gehäuse 1 geöffnet werden soll, werden zuvor die Abdeckprofile 21 entfernt, so daß die Deckelschrauben 7 zugänglich und aus dem Gehäuse-Unterteil 2 herausgeschraubt werden können.

## Patentansprüche

1. Gehäuse, insbesondere für den Einbau elektrischer und elektronischer Bauteile, bestehend aus einem Gehäuse-Unterteil (2) und einem daran befestigbaren Deckel (3), wobei Deckel (3) und Gehäuse-Unterteil (2) über mindestens zwei im Abstand voneinander außerhalb des abgedichteten Innenraums des Gehäuses angeordnete, flexible Innenelemente (19) scharnierartig miteinander verbunden sind, **dadurch gekennzeichnet, daß** die Enden (19.1, 19.2) der flexiblen Innenelemente (19) einen größeren Querschnitt als der zwischen ihnen liegende Bereich aufweisen, wobei mindestens eines der Enden (19.2) zur temporären Querschnittsverringerung einfedernd ausgebildet ist, und im Deckel (3) und im Gehäuse-Unterteil (2) miteinander fluchtende Durchgangsöffnungen (17, 18) vorgesehen sind, deren Querschnitt einen Durchtritt des mindestens einen Endes (19.2) im eingefederten Zustand gestattet, welches nach seinem Durchtritt durch die zugeordnete Durchgangsöffnung (17, 18) zurückfedernd wieder seinen Querschnitt vergrößert.

2. Gehäuse nach Anspruch 1, **dadurch gekennzeichnet, daß** die flexiblen Innenelemente (19) als Kunststoff-Spritzgußteil mit einem angeformten, einfederbaren Rastelement (19.2) an einem ihrer Enden und einer angeformten Verdickung (19.1) an dem anderen ihrer Enden ausgebildet sind.

3. Gehäuse nach Anspruch 2, **dadurch gekennzeichnet, daß** die Durchgangsöffnungen (17) im Deckel (3) zur formschlüssigen und bündigen Aufnahme der angeformten Verdickung (19.1) ausgebildet sind.

4. Gehäuse nach Anspruch 2 oder Anspruch 3, **dadurch gekennzeichnet, daß** das Kunststoff-Spritzgußteil als Band ausgeführt ist, dessen eines Ende nach Art eines Hammerkopfes (19.1) erweitert, und an dessen anderes Ende eine Rastzunge (19.2) nach Art eines Widerhakens angeordnet ist, wobei die Durchgangsöffnungen (17, 18) im Deckel (3) und im Gehäuse-Unterteil (2) entsprechend schlitzartig ausgeführt sind.

5. Gehäuse nach einem der vorstehenden Ansprüche, **dadurch gekennzeichnet, daß** die im Deckel (3) angeordneten Durchgangsöffnungen (17) nach oben abgedeckt sind.

## Claims

1. Housing, in particular for the installation of electric and electronic components, consisting of a housing lower part (2) and a lid (3), which can be fastened thereto, said lid (3) and said housing lower part (2) being connected together with a hinge by means of at least two flexible inner elements (19) arranged at a distance from each other outside the sealed interior space of the housing, **characterized in that** the ends (19.1, 19.2) of the flexible inner elements (19) have a larger cross-section than the area lying between them, wherein at least one of the ends (19.2) is formed compressively in order to temporarily decrease the cross-section and through-openings (17, 18) flush with one another are provided in the lid (3) and in the housing lower part (2), whose cross-section in the compressed state allows passage of the at least one end (19.2), which after its passage through the associated through-opening (17, 18) springs back again thus increasing its cross-section.

2. Housing according to Claim 1, **characterized in that** the flexible inner elements (19) are formed as an injection moulded plastic part with a moulded-on, compressible locking element (19.2) at one of their ends and a moulded-on swelling (19.1) at the other one of their ends.

3. Housing according to Claim 2, **characterized in that** the through-openings (17) are formed in the lid (3) for positive and flush seating of the moulded-on swelling (19.1).

4. Housing according to Claim 2 or Claim 3, **characterized in that** the injection moulded plastic part is implemented as a strip, whose one end extends in the form of a hammer head (19.1) and on whose other end a snap-in pin (19.2) is arranged in the form of a barbed hook, wherein the through-openings (17, 18) are correspondingly implemented slit-like in the lid (3) and in the housing lower part (2).

5. Housing according to any one of the preceding claims, **characterized in that** the through-openings (17) arranged in the lid (3) are upwardly covered.

## Revendications

1. Boîtier, destiné en particulier à l'incorporation de composants électriques et électronique, qui comprend une partie inférieure de boîtier (2), sur laquelle peut être fixé un couvercle (3), le couvercle (3) et la partie inférieure de boîtier (2) étant reliés, l'un à l'autre, à la manière d'une charnière par l'intermédiaire de deux éléments internes souples (19) au moins, qui sont disposés à l'extérieur de l'espace intérieur étanché du boîtier et qui présentent un écart entre eux, **caractérisé en ce que** les extrémités (19.1, 19.2) des éléments internes souples (19) présentent une section transversale plus grande que l'espace se trouvant entre eux, au moins une des extrémités (19.2) étant conçue compressible pour assurer une diminution temporaire de la section transversale, et **en ce que** dans le couvercle (3) et dans la partie inférieure de boîtier (2) sont prévues des ouvertures de passage (17, 18), alignées l'une sur l'autre, dont la section transversale permet le passage, en état comprimé, de cette extrémité (19.2) au moins, qui, une fois passée à travers l'ouverture de passage associée (17, 18), ragrandit, en se détendant, sa section transversale.

2. Boîtier suivant la revendication 1, **caractérisé en ce que** les éléments internes souples (19) sont conçus comme pièce moulée par injection en matière artificielle, sur une des extrémités de laquelle est formé un élément encliquetable compressible (19.2) et sur l'autre extrémité de laquelle est formé un épaississement (19.1).

3. Boîtier suivant la revendication 2, **caractérisé en ce que** les ouvertures de passage (17) sont formées dans le couvercle (3), afin que l'épaississement formé (19.1) soit reçu à fleur et en réalisant une liaison de forme.

4. Boîtier suivant les revendications 2 ou 3, **caractérisé en ce que** la pièce moulée par injection en matière artificielle est conçue comme une bande, dont une des extrémités est élargie à la manière d'une tête de marteau (19.1) et sur l'autre extrémité de laquelle est disposée une languette encliquetable (19.2) qui présente la forme d'un ardillon, les ouvertures de passage (17, 18) dans le couvercle (3) et dans la partie inférieure de boîtier (2) étant, par conséquent, conçues en forme de fente.

5. Boîtier suivant une des revendications précédentes, **caractérisé en ce que** les ouvertures de passage (17) disposées dans le couvercle (3) sont recouvertes sur le dessus.
